# EUROPEAN PATENT SPECIFICATION

(11) **EP 0 293 021 B1**
(45) Date of publication and mention of the grant of the patent: **12.01.1994**
(21) Application number: 88200614.1
(22) Date of filing: 31.03.1988
(51) Int. Cl.: C30B 25/10

(54) **Induction heating system for an epitaxial reactor**
Induktionsheizungsvorrichtung für einen Epitaxiereaktor
Système de chauffage par induction pour réacteur d'épitaxie

(30) Priority: 24.04.1987 IT 2025587
(43) Date of publication of application: 30.11.1988
(73) Proprietor: LPE SPA, 20021 Bollate (IT)
(72) Inventor: Pozzetti, Vittorio, Brugherio (Milano) (IT); Preti, Franco, Milano (IT); Poggi, Piergiovanni, Lugano Cassarate (CH)
(74) Representative: Michelotti, Giuliano

(56) References cited:
- EP-A- 0 147 967
- AU-A- 39 328
- FR-A- 2 567 921
- US-A- 3 645 230
- US-A- 3 964 430
- IBM TECHNICAL DISCLOSURE BULLETIN, vol. 23, no. 3, August 1980, pages 1061-1062, New York, US; J.P. BRONCHARD et al.: "Wafer temperature measurement in epitaxial and pyrolitic deposition equipment"

## Description

The present invention regards improvements to inductors and susceptors usable in epitaxial reactors to increase their yield, reduce parasitic heat production and minimize the temperature gradients in said reactors and specifically in the articles treated therein.

In the semi-conductor industries it is well known the use of epitaxial reactors providing to cover substrate of different materials through epitaxial growth by chemical vapour phase deposition: specifically said reactors are used to provide epitaxial deposition of monocrystal silicon on silicon substrate for the manufacturing of semi-conductor devices.

Among the many epitaxial reactors which historically became popular in the semiconductor industry, distinguishes itself by the excellent features that are specified and claimed in US-A-No. 4,579,080, corresponding to EP-A- 0147967 having as authors John G. Martin et al, using a susceptor having a multi-face prismatic or truncated pyramidal shape , enclosed in an insulating bell jar non reactive in respect of the chemical vapors inside said bell jar, said bell jar being covered by a reflective layer, such as a metallic layer, to reflect the heat irradiated by said susceptor during its operation, in order to reduce the power consumption and to uniform the temperature of said susceptor, and surrounded by a cooling liner cooled by a liquid, such as water, to hold the walls of said bell jar to such a temperature to prevent a substantial deposition on said walls of matters potentially contaminating in the substrates treated in the reactor.

Said bell jar is surrounded by an inductor or coil energized by medium--frequency alternating current (between 1 and 15 kHz) to provide power to heat said susceptor, formed by a conductor wound in many turns properly spaced to provide said susceptor with a power variable from a point to another , as particularly specified at column 12, lines 59, 67 of the above mentioned patent.

If owing to some reason the local power in the susceptor must be changed, the spacing between adjacent turns must be variated through means controlling said turn spacing, which have some mechanical and spacing range problems connected with the dimensions of said conductors. Moreover, where the turn must be held more spaced, the conductors forming the coil do lie on planes no more perpendicular in respect of the susceptor axis and, as a consequence, being the electrical current therein induced parallel to said turns, give a local heating producing the same substantial thermal gradient, which further, owing to the susceptor rotation, produces a time variation or pulsation in the local heating enhancing those thermal gradients, sought to be reduced, with the consequent production of crystal defects or flaws in the substrates or wafers to be treated.

Further the susceptor, formed by a good electrical conductor, such as graphite, possibly covered by a material, such as silicon carbide, well resistant in respect of the chemical reactives and gaseous by product present in the reactor is provided with the thickenings or projections in some regions, such as regions around pockets or indentations housing the substrates or wafer to be heated (see column 8 lines 50-55 of the mentioned US patent) and with thinnings at some other regions, such as the dihedral corners and upper and lower regions ( see column 13 line 66 to column 14 line 14 of the same document), having the purpose to distribute the heat according to desired patterns.

However such patterns required a tedious and time consuming empirical process to find out the best shape giving the best thermal results, producing more uniform temperature profiles across the faces of the sidewalls of the susceptor.

Lastly, it is asserted in said patent that, owing to the heat irradiated by the susceptor and to the heat produced by induced currents within the reflecting metallic layer lining the quartz bell jar, it is very difficult to obtain an efficient cooling by blowing air, and, as a consequence, it is preferred to use water cooling provided by a water crossed liner surrounding said bell jar (see column 11, line 57 to column 12, line 17).

In an attempt to reduce the heat produced by induced currents in reflecting means, such as the reflecting metal layer on the bell jar disclosed in the above mentioned U S patent, FR-A-2 567 921, having the same applicant and the same inventors of the present application, proposed to use a reflecting shield assembly, comprising a plurality of separated water cooled cylindric sectors acting as a reflector for the heat irradiated by the heated susceptor, but having features of substantially open turns with respect to currents induced by the external coil energizing the susceptor itself.

This system, apart the high expense connected with the manufacture of the cylindric sectors, did not result very efficient because at the highest frequencies needed for the proper operation of the reactor (between 10 and 20 KHz) the capacitive coupling among the many sectors allows therein an induced current strong enough to produce a substantial heating and, further, the shielding sectors extendend along the whole height of the susceptor prevent a proper optical detection of the susceptor temperature.

The present invention intends to remedy the above listed problems by embodying an induction heating system for an epitaxial reactor comprising a rotating susceptor, heated by currents induced by a coil, housed in a bell jar of insulating and optically transparent material, such as quartz, surrounded by a reflector for back reflecting to said susceptor the heat therefrom irradiated during the operation, wherein said coil is formed by turns of liquid cooled hollow conductor, each other tightly spaced to have a minimum of gaps therebetween and fastened in a mechanically steady arrangement, characterized in that the internal sides of said turns are optically finished, i. e. mirror reflecting, to operate as a reflector, and, to provide local power variations in the susceptor without moving the turns forming the coil, local variations in the magnetic field produced by the coil are provided by reactive means either subtracting or adding current connected to preselected turns of the coil corresponding to regions of the susceptor in which said power variations are asked and further characterized in that the turns of the coil are comprised of series connected ring shaped conductors, lying on planes substantially perpendicular with respect to the axis of the susceptor in order to induce therein electric currents having direction perpendicular with respect to said axis, to avoid heat pulsations connected to some lack of perpendicularity in said currents with respect to the rotating susceptor and the reactive means subtracting current from the preselected turns consist of inductors while the reactive means adding current to said turns consist of capacitors both connected to said preselected turns.

Preferably, to make particularly efficient the air cooling of the bell jar, is used a blower providing air through a nozzle and swirl generator and between said bell jar and said coil, then coming out said air from around the bell jar to pass through a heat exchanger in order to come back to said blower.

More preferably, the air from said blower enters a pressurized chamber and therefrom passes between the bell jar and the coil through both said nozzle and swirl generator and through supplementar taps consisting of gaps between the turns of said coil.

Further, the inductors subtracting current from preselected turns of the coil are variable.

Specifically, the inductors are made variable by connection of taps thereof to a short circuit conductor.

In alternative, the inductors are made variable by means of a ferromagnetic core therein movable.

Further, the capacitors adding current to preselected turns of the coil are variable.

Preferably, said capacitors are made incrementally variable by shunt connection of a selectable number of capacitor members.

In a further embodiment, the current subtracting and adding means are integrated in a combination of at least one inductor and one capacitor.

Preferably, said combination of at least one inductor and one capacitor is a parallel combination thereof having the capacitor incrementally variable and the inductor variable by means of a ferromagnetic movable core.

Alternatively, the combination of at least one inductor and one capacitor can be a series combination thereof having the capacitor incrementally variable and the inductor variable by means of a ferromagnetic movable core.

Further, across said capacitor is connected a voltage limiting member to limit possible overvoltages which could be formed in said capacitor near resonance conditions.

In a further embodiment the induction coil is provided with ferromagnetic blocks having the purpose of guiding and limiting the magnetic field outside of the coil. Preferably, said blocks have an angular shape and are provided around the top and bottom edge of said coil, respectively.

Particularly, said blocks consist of ferromagnetic lamination stacks.

Alternatively, said blocks consist of ceramic ferrite.

In a further embodiment said ferromagnetic blocks are connected by an external ferromagnetic shell around the outside of said coil.

Preferably, said blocks and said shell consist of ceramic ferrite.

Alternatively, said ferrite blocks are connected by ferrite columns outside of said coil.

According to a further embodiment, the induction heating system for an epitaxial reactor of the present invention, comprising a susceptor consisting of an electrically conducting shell having shape of a trucated pyramid with regular polygonal basis and provided with external and internal surfaces, is characterized in that the internal surface of said shell is provided with depressions or relieves aligned and substantially coextensive with pockets or indentations on said external surface accomodating wafers or slices of material to be trated.

Preferably, the thickness variations of the susceptor compensate for induced power variations connected with the pyramidal shape of said susceptor.

Specifically, said depressions aligned with said pockets are planar depressions having shape of circular trenches surrounding a central area substantially at the same level of said internal surface.

Alteratively, said depressions are circular trenches with a bevel starting from a central area substantially at the same level of said internal surface.

Further alternatively said relieves are generally conical surfaces, on the internal surface of said susceptor having vertices substantially aligned with the centers of said pockets.

In addition, the lateral corners of the susceptor are provided with bevels well larger outside than inside in order to maintain or reduce locally the susceptor thickness and thus maintain or increase locally the current density thereinto.

The features and the advantages of the present invention, together with other objects thereof, will be clear from the following detailed description of an embodiment thereof, given for exemplicative and non limiting purposes, provided with the enclosed drawings, in which:
- fig 1 is a diagramatical sectional view of the epitaxial reactor according to the present invention;
- fig. 2 is a view, taken along the line 2-2 of figure 1 specifically depicting an air swirling blowing and distributing system according to the present invention;
figure 3, depicts in the sections a) to d) different kinds of reactive circuits differently regulatable to control the current in the individual turns of the coil;
figure 4 depicts the impedance and phase features of a reactive circuit according to fig. 3c;
figure 5 depicts the current absorbed from or provided to a coil by a reactive circuit according to figure 3c, in accordance with various inductance and capacity values;
figure 6 is an axial sectional view of a coil and susceptor assembly provided at the ends with angularly shaped blocks of ferromagnetic material to reduce the electromagnetic field dispersion outside the coil;
figure 7 is a view along line 7-7 of figure 6;
figure 8 is an axial sectional view of the coil and susceptor assembly provided with a whole ferromagnetic shell to reduce at most the dispersion of electromagnetic fields;
figure 9 is a view along line 9-9 of figure 8;,
figure 10 is formed by back, lateral in cross-section and front views, respectively of a part of susceptor back provided with a depression having shape of a circular planar trench;
figure 11 is formed by back, lateral in cross-section and front views, respectively, of a part of susceptor back provided with depression having shape of a circular trench outside bevelled;
figure 12 is formed by back, lateral in cross-section and front views respectively of a part of susceptor provided with a generally conical relief outwardly increasing.

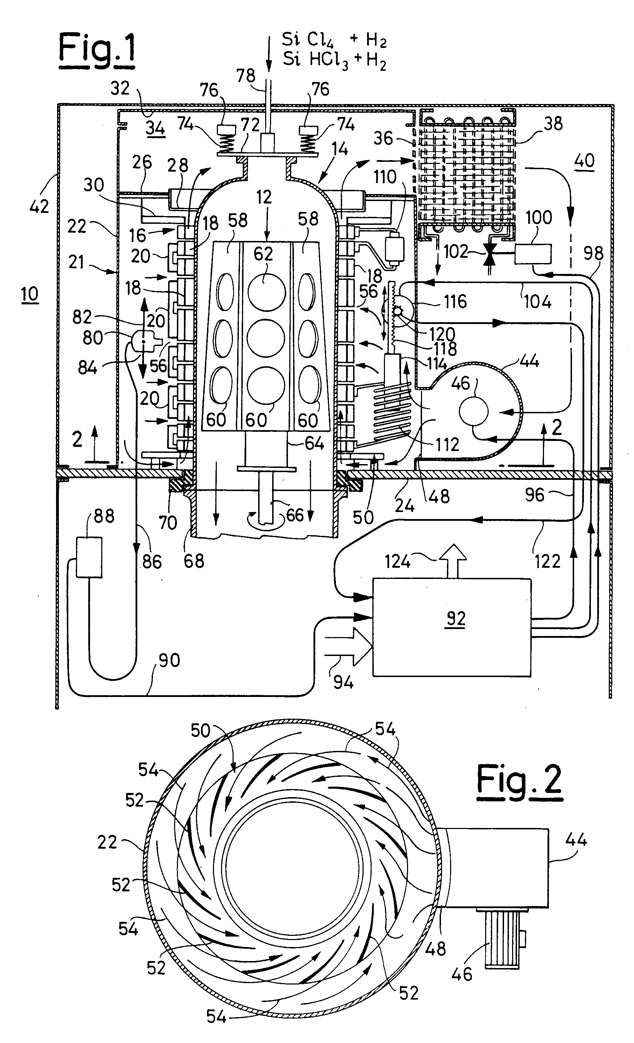

Referring to fig. 1, it is seen that an expitaxial reactor 10, according to the present invention, is formed by a susceptor 12 rotatable and introducible in an insulated and possibly transparent bell jar 14, usually a quartz, bell jar. Said bell jar 14 is surrounded by a coil 16 formed by many turns 18 shaped as planar rings, open on a side and connected to each other by conducting bridges or jumpers 20, providing the electric connection between adjacent turns. The turns are essentially formed by a hollow conductor, such as rectangular pipe, crossed by a cooling liquid, such as water, to be maintained to work temperatures, consistent with the proper reactor operation. Specifically, it is to note that the hollow conductors, formed by the turns 18 of the coil 16 have different heights according to their position in the coil, being lower at the ends of the coil 16 and higher in an intermediate region thereof in order to permit higher current densities and thus higher heating power, in the end regions of the susceptor 12 and lower densities in the intermediate regions thereof.

The inductor 16 and bell jar 14 assembly is enclosed in a pressurized chamber 21 formed by a cylindrical wall 22 abutting on a lower plane 24 and top closed by a dividing plane 26, provided with a structure 28 centering said bell jar 14 and with a structure 30 sustaining the coil 16, which with an upper cover 32 defines an upper chamber 34 communicating through a window 36 with an air-water heat exchanger 38 in turn connected with an external chamber 40 defined by an external metallic cabinet 42, abutting too on the plane 24, and enclosing the whole air circuit surrounding the bell jar 14. A blower 44, actuated by a motor 46, intakes air from the external chamber 40, admitting it in the pressurized chamber 21, through an opening 48. From here the air passes licking the bell jar 14 through a swirl generating nozzle 50, provided with deflecting and conveying blades 52, providing the air with a swirling movement, evidenced by arrows 54 (see specifically figure 2). Further to pass through the nozzle 50, the cooling air can pass through the separating gaps 56 between the single turns 18 of the coil 16, enhancing the turbulence which helps the heat removal from the walls of the quartz bell jar 14.

Said gaps 56 can be also provided with opening regulating iris diaphragms to affect the air flux through them and thus the wall temperature of the bell jar 14.

The susceptor 12 having shape of truncated pyramid with a polygonal basis (hexagonal in this examples), is provided with a plurality of faces 58 in which are cut pockets or indentations 60 housing wafers or slices 62 of material to be treated, such as the tipical silicon wafers to be submitted to epitaxial growth. Said susceptor 12, brought by a support 64 is rotated by a shaft 66 passing through a suitable sealing support and actuated by a motor (not shown), said support being integral with a pushing support 68 abutting against the lower basis of the bell jar 14, to keep it pushed against a gasket 70, comprised between the bell jar basis and the lower plane 24 and against a sealing pierced plate 72, pushed by springs 74 abutting against supports 76, permitting to introduce through a pipe 78 the gases to the used in the epitaxial reactor, as for example, SiCl₄, SiHCl₃ , H₂ and other gaseous components, such as aluminium and phosphor compounds, to assure the proper silicon doping.

The susceptor 12 temperature, during the reactor operation is detected by at least one optical pyrometer 80, movable according to the arrows 82 and 84, surveying the susceptor 12 through the gaps 56 between the turns 18 of the coils 16, and connected through a cable 86 to a first processing center 88, as for example an anologic to digital conveter (A/D) which through a cable 90 sends temperature data to a central processor 92 receiving through a multiple bus 94 all the directions and data for the managing of the whole expitaxial reactor and emitting the regulating signals, as for example a first signal through a line 96, to control the speed of the motor 46 actuating the blower 44, a second signal through a line 98 for an actuator 100 of a flux regulating valve 102 to regulate the cooling water flux in the air-water heat exchanger 38 and a thrid signal through a line 104 for the current control in single turns of the coil 16 according to a system hereinafter disclosed.

Alternativelty, instead of a single movable pyrometer 80, can be used a plurality of optical pyrometers, suitably positioned in many suitably chosen surveying points and by turn connectable to the above mentioned first processing center 88 through one of many electronic switching circuits widely diffused and well-known in the present information processing art.

As already stated, it is possible to localy variate the current in specifical turns of the coil 16, shunt connecting them to capacitors such as the capacitor 110, or to inductors, such as the inductor 112, which can be variated by means the use of cores, such as the ferromagnetic core 114 introducible in or withdrawable from the same through an actuator 116, such as a motor acting on the racked rod 118 connected to said ferromagnetic core 114. Said ferromagnetic core can be formed by a stack of laminations particularly thin and well insulated, suitable for the frequencies (1 kHz to 20 kHz) of the current energizing the inductor 16, or by a cylindric ceramic ferrite rod, having high magnetic permeability and standing high magnetic fields, of the kind used in transformers for voltage converters controlled by seminconductor devices.

The racked rod 118, moved by the actuator 116, is also provided with a position transducer 120, having the duty to inform the central processor 92, through a line 122, about the position of the core 114 within the turns of the inductor 112.

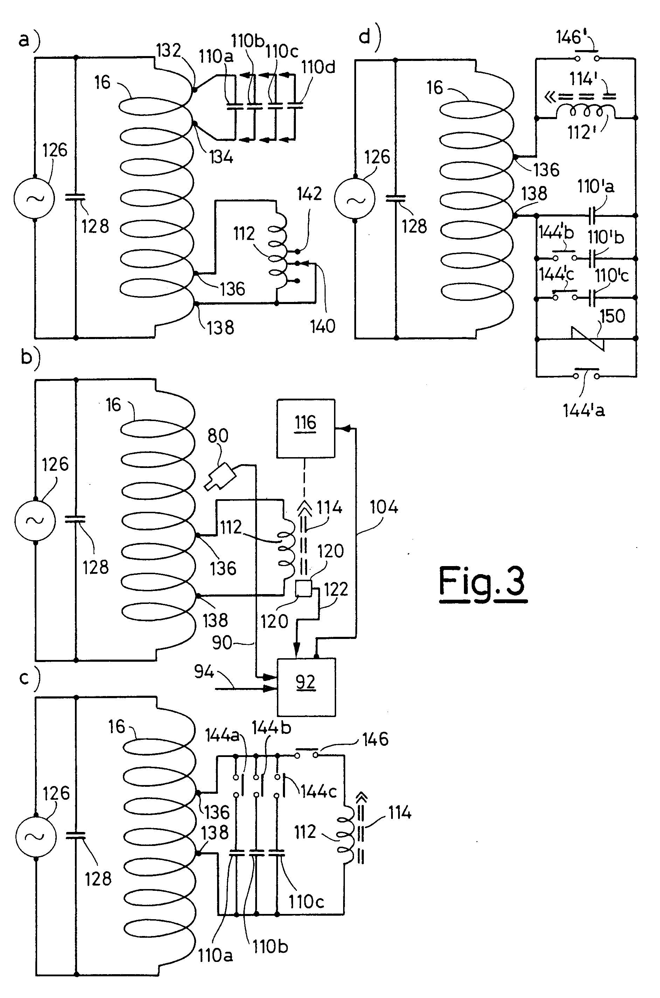

The possibility for controlling locally the current in specific turns of the coil 16 in order to control locally the electromagnetic field and thus the power induced in the susceptor 12, can be better understood by referring to figures 3, 4 and 5.

Reference is made to the simpler case in figure 3a. A coil 16 is fed by an alternating current generator, indicated by the numeral 126 and resonates at the frequency of the generator 126 by means of a shunt connected capacitor 128 duly shaped to produce such a resonance.

If some taps at indicated turns of the coil 16 are considered, said taps permit the coil 16 to work as an autotransformer and if some reactive loads are connected to said taps, it is possible to derivate a current between a pair of said taps.

Due to the fact that the reactive load is inductive or capacitive in nature, the current derivated between said two taps is subtratcted from or added to the current in the coil turns. According to the example depicted in the figure 3a, between the tap pair 132 and 134 can be connected some capacitors 110a, 110b, 110c etc..., in order to obtain some selectable current increases between said tap pair . Owing to the very high current crossing said capacitory sometime water cooled, it is preferable that the connections to said capacitors are hand performed by means of proper connectors through the help of suitable tools used to move fastening screws or bolts.

In a like way between the tap pair 136 and 138 of the same coil 16 is connected a load inductor 112, provided with a short circuit conductor 140, consisting for example of a plate connectable by means of bolts between taps 142 of adjacent turns of said load inductor 112. The kind of the here above mentioned control can be just hand connected and controlled and can produce just some preselected fixed regulations of the current in the coil 16. Moreover to perform said regulations, the power to the coil 16 must be disconnected, and as a consequence, the work and production of the reactor must be shut-down.

In order to have a continuous and automated regulation of a current, derived for example between the tap pair 136 and 138, the assembly in figure 3b is used. In this figure the inductance of the inductor 112, connected between the taps 136 and 138 is varied by moving a ferromagnetic core 114 in and out said inductor, said core being moved by an actuator 116 controlled through a line 104 by the central processor 92, receiving from a line 90 signals coming from an optical pyrometer 80, measuring the susceptor temperature and thus the local power density connected with the current in invidual turns of the coil 16, and from a line 122 position data produced by a transducer 120 referring about the core 114 position within the inductor 112. The above mentioned device, depicted both in figures 3b and 1, permits to variate continuously, controllably and automatically the current derived between the taps 136 and 138 of the coil 16.

The further improvement of the reactive load circuit of the coil 16 depicted in figure 3c, consists in a combination of many capacitors 110a, 110b, 110c, .... connectable between the taps 136 and 138 , possibly shunting the inductor 112 variable by means of the movable ferromagnetic core 114.

A switch or relay contact assembly 144a, 144b, 144c, ... and 146 permit the shunt connection of one ore more capacitors and/or the variable inductor 112. What is obtained is a parallel resonant circuit which, by variating its constants (i.e. inductance and/or capacitance) resonates to frequencies higher or lower with respect to the generator 126 frequency giving the reactive circuit either inductive or capacitive features, respectively and permitting through the simple variation of the inductor 112, to continuously change the features of said circuit from capacitive to inductive and vice versa, permitting a particular versability of the coil 16.

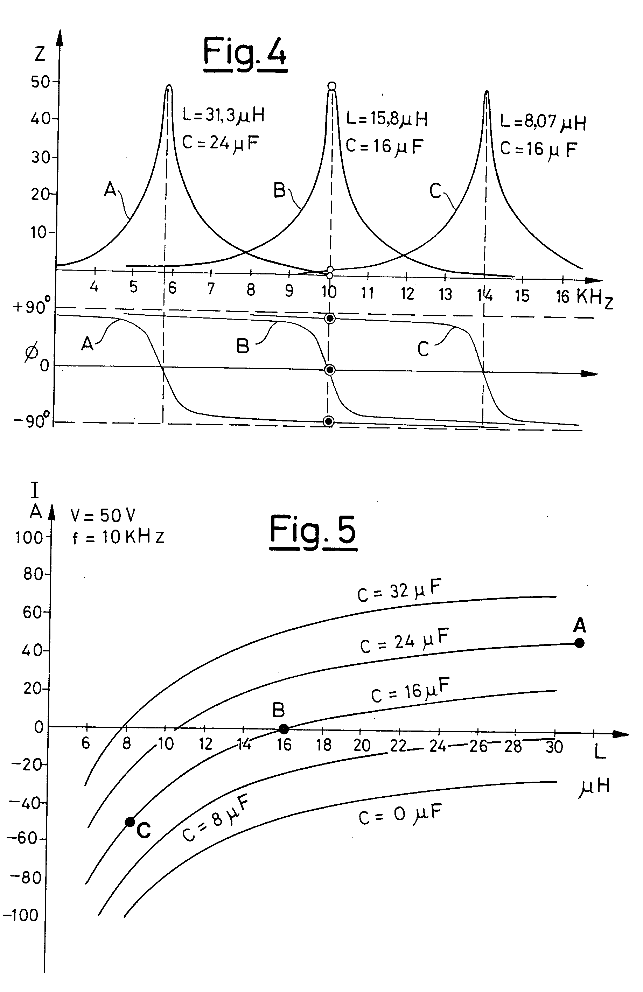

The specific operation of said reactive circuit will be explained with reference to the diagrams of figures 4 and 5.

A further reactive circuit having too features variable between inductive and capacitive ones is that depicted in figure 3d. In said circuit there are some capacitors 110'a, 110'b, 110'c.... shunt connectable each other and successively series connected with a variable inductor 112' provided with a movable core 114'. This reactive circuit is actually a series resonant circuit which, by variating its constants, can resonate at frequencies lower or higher with respect to the generator 126 frequency, giving the reactive circuit capacitive or inductive features, respectively. Some switches or relay contacts 144'b, 144'c, permit to shunt connect the capacitors 110'b, 110'c, in respect of the capacitors 110'a, while a further switch or relay contact 144'a short circuits, excluding them, all the capacitors 110'a, to 110'c, and a further switch or relay contact 146', short circuits, excluding it, the inductor 112'. This reactive circuit, formed by a series connected resonant circuit can work equivalentely to the parallel resonant circuit, having however the drawback that near the resonance frequency the circuit could stand too high currents and further across the reactive members can develop such high voltages to suggest the provision, at least across the capacitors 110'a to 110'c of a voltage limiting member 150, such as a voltage dependent resistor (VDR) or varistor, to protect them against such overvoltages.

For a full understanding of the operation of the figure 3c circuit, which is the most preferred, reference is now made to figures 4 and 5, depicting impedance and phase angle, between voltage and current, diagrams , respectively, for different inductance and capacity combinations and diagrams for currents added to or subtracted from the coil 16 for different capacitors against a continuous inductance variation.

According to the diagrams A, a circuit having a 31.3 microhenries inductance and a 24 microfarads capacity resonating at the 5.75 kHz frequency, behaves at the 10 kHz frequency as an almost pure capacitor, having of course lesser capacity. According to the diagrams B, a circuit having a 15.8 microhenries inductance and a 16 microfarads capacity, resonating exactly at 10 kHz, behaves as a pure resistor, while according to the diagrams C a circuit having a 8.07 microhenries inductance and 16 microfarads capacity, resonating at 14 kHz, behaves at the 10 kHz frequency, as an almost pure inductor, having of course lesser inductance.

Figure 5 clearly depicts how, by variating the inductor 112 for a given capacity of the capacitors 110, it is possibile to go from a current subtratcted from the turns of the coil 16 to a current added or introduced in said turns. For example the first diagram marked out for a 32 microfarads capacity, depicted that with a 6 microhenries inductance the reactive circuit subtracts a 30 amperes current from coil 16 turns on which a 50 volts voltage is formed (this, of course, at 10 kHz frequency), while with a 30 microhenries inductance adds to said turns an about 70 amperes current with the current being substantially zeroed for a 8 microhenries inductance at which there is the 10 kHz resonance.

With a 24 microfarads capacity and a 6 microhenries inductance, the circuit subtracts a 55 amperes current from and with a 30 microhenries inductance introduces a current of about 45 amperes in the coil 16, being said current substantially zeroed at the resonance condition at 10 kHz provided by an about 10.5 microhenries inductance. The remaining diagrams can be understood in a similar way, remarking that by lowering the capacity with the same inductance the current subtracted from the coil 16 is increased while the current admitted to the coil 16 is decreased.

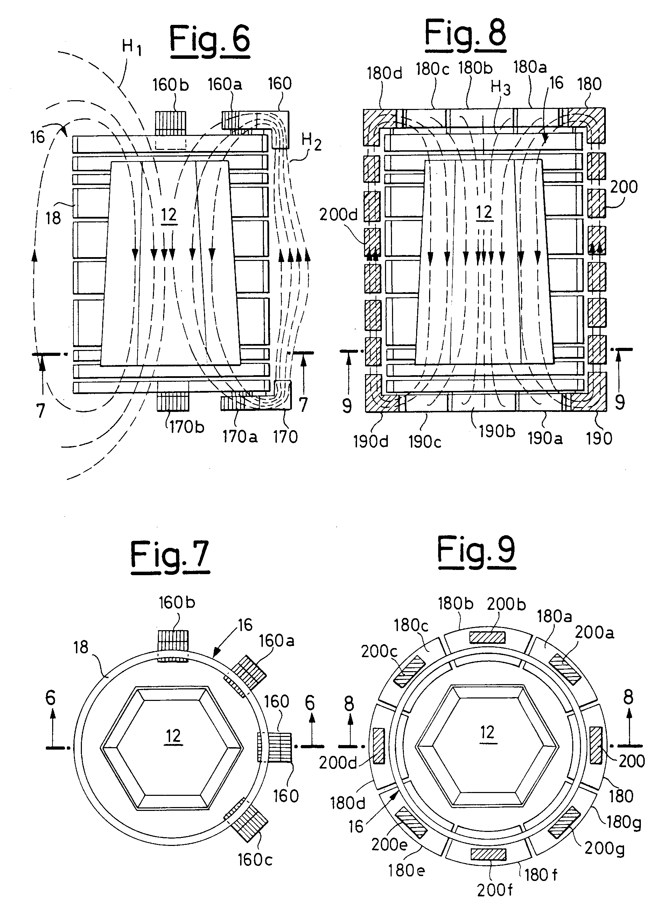

Reference is now made to figures 6 and 7 in which is depicted a first assembly to reduce the dispersion of the magnetic field produced by the coil 16, outside the same. Said dispersion reduction is obtained by providing some angularly shaped blocks 160, 160a, 160b, ... and 170, 170a, 170b,... of ferromagnetic material near the upper and the lower edge of the coil 16, respectively. Said blocks, made for example of very thin silicon-steel laminations, to take into account the operating frequency, guide the ferromagnetic field reshaping it from the highly dispersed form indicated by the simbol H₁ to the more concentrated and near the coil 16 form indicated by the symbol H₂. It is evident that outside the coil 16 the field H₂ reduces itself faster than the field H₁, strongly reducing the heating of metallic components which can be immersed in said field, however the lesser heating of said metallic components finds a negative counterbalance in the heating of the blocks 160-170 which, because of the high power, can require a water cooling thereof.

The last mentioned drawback can be very reduced replacing the lamination blocks 160-170, depicted in figures 6 and 7, with blocks 180-190, depicted in figures 8 and 9 of magnetic material, electrically little conductive or insulating, such as the well known ceramic ferrites which, moreover, have very little power losses at the operating frequencies.

Further considering figures 8 and 9, it is seen that blocks 180, 180a, 180b, etc. surround the top edge of the coil 16 and the blocks 190, 190a, 190b, etc... surround the bottom edge of the same coil 16, permitting the shaping of a magnetic field H₃ between the inside of the coil 16 and external paths formed by said blocks 180, 180a-180g, and 190a, 190a-190g, and by columns 200,200a-200g connecting the above mentioned blocks in order to reduce at the minimum the magnetic field dispersion outside the coil 16.

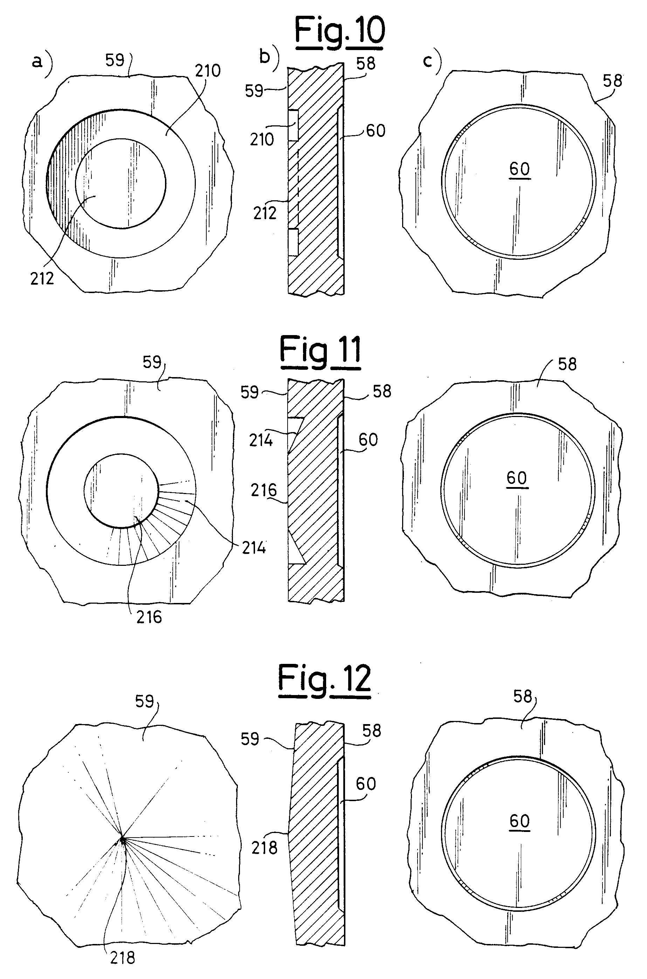

In order to assure specifical heating profiles to the indentations or pockets 60, having the purpos to accomodate wafers or slices of the material to be treated, on the faces 58 of the susceptor 12, can be used specifical shapes of the internal faces 59 of the susceptor 12, aligned with said pockets 60, as depicted in figures 10, 11 and 12. Particularly in figure 10 behind the pocket 60 is provided a depression 210, having shape of a circular trench, surrounding a planar area 212 at the same level of the remaining face 59. In figure 11, behind the pocket 60, is provided a bevelled depression 214 having shape of a circular corona, gradually rising from the external to the internal circumference, to reach a planar area 216 at the same level of the face 59. In figure 12, behind the pocket 60, is provided a continous relief, reminding a conical surface, having top in a vertex 218 substantially aligned with the center of the pocket 60.

Everyone of these indentation or relieves depicted in figures 10, 11 and 12 produces in the pockets 60 temperature profiles obvious to people skilled in the art, having in mind that to a lesser susceptor thickness corresponds higher temperature in the susceptor and thus in the wafer accomodated in said pockets 60.

A further measure, to be taken is to provide the lateral corners of the susceptor 12 with bevellings larger outside than inside in order to maintain constant or reduce locally the susceptor thickness and thus maintain constant or increase locally the current density therein.

In the present specification there have been depicted as an example, some improvements to coils and susceptor of epitaxial reactors permitting them a particularly proper operation required for treating wafers accomodated in the pockets 60 of the susceptors 12.

Obviously, a person skilled in the art will be able to find out approaches and measures wholly or partially equivalent to those depicted in the present specification and it is here intended to cover all said equivalent measures and approaches falling in the scope of the present invention ad defined by the following claims.

## Claims

1. Induction heating system for an epitaxial reactor comprising a rotating susceptor (12), heated by currents induced by a coil (16), housed in a bell jar (14) of insulating and optically transparent material, such as quartz, surrounded by a reflector for back reflecting to said susceptor (12) the heat therefrom irradiated during the operation, wherein said coil (16) is formed by turns (18) of liquid cooled hollow conductor, each other tightly spaced to have a minimum of gaps therebetween and fastened in a mechanically steady arrangement, characterized in that the internal sides of said turns (18) are optically finished, i. e. mirror reflecting, to operate as a reflector, and, to provide local power variations in the susceptor (12), local variations in the magnetic field produced by the coil (16) are provided by reactive means either subtracting or adding current connected to preselected turns (18) of the coil (16) corresponding to regions of the susceptor (12) in which said power variations are asked and further characterized in that the turns (18) of the coil (16) are comprised of series connected ring shaped conductors, lying on planes substantially perpendicular with respect to the axis of the susceptor (12), in order to induce therein electric currents having direction perpendicular with respect to said axis, to avoid heat pulsations connected to some lack of perpendicularity in said currents with respect to the rotating susceptor (12) and the reactive means subtracting current from the preselected turns (18) consist of inductors (112), while the reactive means adding current to said turns consist of capacitors (110) both connected to said preselected turns (18).

2. Induction heating system, according to claim 1, characterized by a blower (44) providing air to cool said bell jar (14) through a nozzle and swirl generator (50) and between said bell jar (14) and said coil (16), then coming out said air from around the bell jar (14) to pass through a heat exchanger (38) in order to come back to said blower (44).

3. Induction heating system, according to claim 2, characterized in that the air from said blower (44) enters a pressurized chamber (21) and therefrom passes between the bell jar (14) and the coil (16) through both said nozzle and swirl generator (50) and through supplementar taps consisting of gaps (56) between the turns (18) of said coil (16).

4. Induction heating system, according to claims 1 to 3, characterized in that said inductors (112) are variable.

5. Induction heating system, according to claim 4, characterized in that the inductors (112) are made variable by connection of taps thereof to a short circuit conductor (140).

6. Induction heating system, according to claim 4, characterized in that the inductors (112) are made variable by means of a ferromagnetic core (114) therein movable.

7. Induction heating system, according to claims 1 to 3, characterized in that said capacitors (110) are variable.

8. Induction heating system, according to claim 7, characterized in that said capacitors (110) are made incrementally variable by shunt connection of a selectable number of capacitor members.

9. Induction heating system, according to claims 1 to 3, characterized by the combination of at least one inductor (112) and one capacitor (110).

10. Induction heating system, according to claim 9, characterized in that said combination of at least one inductor (112) and one capacitor (110) is a parallel combination thereof having the capacitor (110) incrementally variable and the inductor (112) variable by means of a ferromagnetic movable core (114).

11. Induction heating system, according to claim 9, characterized in that the combination of at least one inductor (112') and one capacitor (110') is a series combination thereof having the capacitor (110') incrementally variable and the inductor (112') variable by means of a ferromagnetic movable core (114').

12. Induction heating system, according to claim 11, characterized in that across said capacitor (110') is connected a voltage limiting member (150) to limit possible overvoltages which could be formed in said capacitor (110') near resonance conditions.

13. Induction heating system, according to claim 1, characterized in that said coil (16) is provided with ferromagnetic blocks (160, 170, 180, 190) having the purpose of guiding and limiting the magnetic field outside of the coil (16).

14. Induction heating system, according to claim 13, characterized in that said blocks (160, 170, 180, 190) have an angular shape and are provided around the top and bottom edge of said coil, respectively.

15. Induction heating system, according to claim 14, characterized in that said blocks (160, 170, 180, 190) consist of ferromagnetic lamination stacks.

16. Induction heating system, according to claim 14, characterized in that said blocks (160, 170, 180, 190) consist of ceramic ferrite.

17. Induction heating system, according to claim 13, characterized in that said ferromagnetic blocks (160, 170, 180, 190) are connected by an external ferromagnetic shell around the outside of said coil (16).

18. Induction heating system, according to claim 17, characterized in that said blocks (160, 170, 180, 190) and said shell consist of ceramic ferrite.

19. Induction heating system, according to claim 16, characterized in that said ferrite blocks (160, 170, 180, 190) are connected by ferrite columns (200) outside of said coil (16).

20. Induction heating system for an epitaxial reactor, according to claim 1, comprising a susceptor (12), consisting of an electrically conducting shell having shape of a trucated pyramid with regular polygonal basis and provided with external (58) and internal (59) surfaces, characterized in that the internal surface (59) of said shell is provided with depressions or relieves aligned and substantially coextensive with pockets or indentations (60) on said external surface (58) accomodating wafers or slices (62) of material to be trated.

21. Induction heating system, according to claim 20, characterized in that thickness variations of the susceptor (12) compensate for induced power variations connected with the pyramidal shape of said susceptor (12).

22. Induction heating system, according to claims 20 and 21, characterized in that said depressions aligned with said pockets (60) are planar depressions having shape of circular trenches (210), surrounding a central area (212) substantially at the same level of said internal surface (59).

23. Induction heating system, according to claims 20 and 21, characterized in that said depressions are circular trenches (214) with a bevel starting from a central area (216) substantially at the same level of said internal surface (59).

24. Induction heating system, according to claims 20 and 21, characterized in that said relieves are generally conical surfaces, on the internal surface (59) of said susceptor (12), having vertices (248) substantially aligned with the centers of said pockets (60).

25. Induction heating system, according to claims 20 to 24, characterized in that the lateral corners of the susceptor (12) are provided with bevels well larger outside than inside in order to maintain or reduce locally the susceptor (12) thickness and thus maintain or increase locally the current density thereinto.

## Patentansprüche

1. Induktionsheizsystem für einen Epitaxierreaktor mit einem drehbaren Aufnehmer (12), der durch Ströme erhitzt wird, die von einer Spule (16) erzeugt werden, und in einer Behälterglocke (14) aus isolierendem und optisch transparentem Material, wie beispielsweise Quarz, aufgenommen ist, und von einem Reflektor umgeben ist, um zum Aufnehmer (12) die von diesem während des Betriebs ausgestrahlte Wärme zurückzureflektieren, wobei die Spule (16) durch Windungen (18) eines flüssigkeitsgekühlten Hohlleiters gebildet ist, die jeweils eng beabstandet so angeordnet sind, daß dazwischen minimale Spalte vorhanden sind, und in einer mechanisch stabilen Anordnung befestigt sind,
**dadurch gekennzeichnet,** daß
die Innenseiten der Windungen (18) optisch feinbearbeitet sind, also spiegelreflektierend, so daß sie als ein Reflektor arbeiten, und daß zur Bereitstellung lokaler Leistungsvariationen in dem Aufnehmer (12) lokale Variationen des von der Spule (16) erzeugten Magnetfeldes durch eine Reaktionseinrichtung bereitgestellt werden, welche entweder Strom abzieht oder hinzufügt und an vorbestimmte Windungen (18) der Spule (16) entsprechend Bereichen des Aufnehmers (12) angeschlossen ist, in welchen die Leistungsvariationen gewünscht sind, und daß weiterhin die Windungen (18) der Spule (16) aus in Reihe geschalteten ringförmigen Leitern bestehen, die in Ebenen im wesentlichen senkrecht zur Achse des Aufnehmers (12) liegen, um dort elektrische Ströme zu induzieren, deren Richtung senkrecht zur Achse verläuft, um Wärmeschwankungen zu vermeiden, die mit einer Abweichung von der senkrechten Ausrichtung der Ströme in bezug auf den drehbaren Aufnehmer (12) zusammenhängen, wobei die Reaktionseinrichtung, welche von den vorbestimmten Windungen (18) Strom abzieht, aus Induktoren (112) besteht, während die Reaktionseinrichtung, welche den Windungen Strom zufügt, aus Kondensatoren (110) besteht, und die Induktoren und Kondensatoren beide an die vorbestimmten Windungen (18) angeschlossen sind.

2. Induktionsheizsystem nach Anspruch 1, gekennzeichnet durch ein Gebläse (44), welches Luft zur Kühlung der Behälterglocke (14) durch eine Düse und einen Wirbelgenerator (50) und zwischen der Behälterglocke (14) und der Spule (16) zur Verfügung stellt, wobei die Luft dann um die Behälterglocke (14) herausgelangt, und durch einen Wärmetauscher (38) gelangt, um dann zum Gebläse (44) zurückgeführt zu werden.

3. Induktionsheizsystem nach Anspruch 2, dadurch gekennzeichnet, daß die Luft von dem Gebläse (44) in eine unter Druck stehende Kammer (21) eintritt und von dieser zwischen der Behälterglocke (14) und der Spule (16) sowohl durch die Düse und den Wirbelgenerator (50) und durch zusätzliche Anschlüsse gelangt, welche aus Spalten (56) zwischen den Windungen (18) der Spule (16) bestehen.

4. Induktionsheizsystem nach Anspruch 1 bis 3, dadurch gekennzeichnet, daß die Induktoren (112) variabel sind.

5. Induktionsheizsystem nach Anspruch 4, dadurch gekennzeichnet, daß die Induktoren (112) dadurch variabel ausgebildet sind, daß deren Anzapfungen mit einem Kurzschlußleiter (140) verbunden sind.

6. Induktionsheizsystem nach Anspruch 4, dadurch gekennzeichnet, daß die Induktoren (112) dadurch variabel ausgebildet sind, daß ein in ihnen bewegbarer ferromagnetischer Kern (114) vorgesehen ist.

7. Induktionsheizsystem nach Anspruch 1 bis 3, dadurch gekennzeichnet, daß die Kondensatoren (110) variabel ausgebildet sind.

8. Induktionsheizsystem nach Anspruch 7, dadurch gekennzeichnet, daß die Kondensatoren (110) durch eine Parallelschaltung einer auswählbaren Anzahl von Kondensatorgliedern stufenweise variabel ausgebildet sind.

9. Induktionsheizsystem nach Anspruch 1 bis 3, gekennzeichnet durch die Kombination zumindest eines Induktors (112) und eines Kondensators (110).

10. Induktionsheizsystem nach Anspruch 9, dadurch gekennzeichnet, daß die Kombination zumindest eines Induktors (112) und eines Kondensators (110) eine Parallelschaltung dieser Bauteile darstellt, wobei der Kondensator (110) stufenweise variabel ausgebildet ist, und der Induktor (112) mittels eines ferromagnetischen, bewegbaren Kerns (114) variabel ausgebildet ist.

11. Induktionsheizsystem nach Anspruch 9, dadurch gekennzeichnet, daß die Kombination zumindest eines Induktors (112') und eines Kondensators (110') eine Reihenschaltung dieser Bauteile darstellt, wobei der Kondensator (110') stufenartig variabel ausgebildet ist, und der Induktor (112') mit Hilfe eines ferromagnetischen, bewegbaren Kerns (114') variabel ausgebildet ist.

12. Induktionsheizsystem nach Anspruch 11, dadurch gekennzeichnet, daß über den Kondensator (110') ein Spannungsbegrenzungsglied (150) geschaltet ist, um mögliche Überspannungen zu begrenzen, die in dem Kondensator (110') in der Nähe der Resonanzbedingungen erzeugt werden könnten.

13. Induktionsheizsystem nach Anspruch 1, dadurch gekennzeichnet, daß die Spule (16) mit ferromagnetischen Blöcken (160, 170, 180, 190) versehen ist, welche zum Zweck der Führung und Begrenzung des Magnetfeldes außerhalb der Spule (16) vorgesehen sind.

14. Induktionsheizsystem nach Anspruch 13, dadurch gekennzeichnet, daß die Blöcke (160, 170, 180, 190) eine Kreisringform aufweisen und um die Oberkante bzw. die Unterkante der Spule herum vorgesehen sind.

15. Induktionsheizsystem nach Anspruch 14, dadurch gekennzeichnet, daß die Blöcke (160, 170, 180, 190) aus ferromagnetischen Laminatstapeln bestehen.

16. Induktionsheizsystem nach Anspruch 14, dadurch gekennzeichnet, daß die Blöcke (160, 170, 180, 190) aus keramischem Ferrit bestehen.

17. Induktionsheizsystem nach Anspruch 13, dadurch gekennzeichnet, daß die ferromagnetischen Blöcke (160, 170, 180, 190) durch eine externe, ferromagnetische Ummantelung außerhalb der Außenseite der Spule (16) verbunden sind.

18. Induktionsheizsystem nach Anspruch 17, dadurch gekennzeichnet, daß die Blöcke (160, 170, 180, 190) und die Ummantelung aus keramischem Ferrit bestehen.

19. Induktionsheizsystem nach Anspruch 16, dadurch gekennzeichnet, daß die Ferritblöcke (160, 170, 180, 190) durch Ferritsäulen (200) außerhalb der Spule (16) verbunden sind.

20. Induktionsheizsystem für einen Epitaxierreaktor nach Anspruch 1, mit einem Aufnehmer (12), der aus einer elektrisch leitfähigen Ummantelung besteht, welche die Form einer abgeschnittenen Pyramide mit einer regelmäßigen Polygonbasis aufweist und mit äußeren (58) und inneren (59) Oberflächen versehen ist, dadurch **gekennzeichnet,** daß die innere Oberfläche (59) der Ummantelung mit Vertiefungen oder Ausnehmungen versehen ist, die zu Taschen oder Einsenkungen (60) auf der äußeren Oberfläche (58) ausgerichtet sind und im wesentlichen zusammen mit diesen verlaufen, welche Wafer oder Scheiben (62) eines zu behandelnden Materials aufnehmen.

21. Induktionsheizsystem nach Anspruch 20, dadurch gekennzeichnet, daß Dickenvariationen des Aufnehmers (12) induzierte Leistungsvariationen kompensieren, welche mit der Pyramidenform des Aufnehmers (12) zusammenhängen.

22. Induktionsheizsystem nach Anspruch 20 und 21, dadurch gekennzeichnet, daß die Vertiefungen, die bezüglich der Taschen (60) ausgerichtet sind, ebene Vertiefungen sind, welche die Form kreisförmiger Gräben (210) aufweisen, die einen zentralen Bereich (212) im wesentlichen auf demselben Pegel der inneren Oberfläche (59) umgeben.

23. Induktionsheizsystem nach Anspruch 20 und 21, dadurch gekennzeichnet, daß die Vertiefungen kreisförmige Gräben (214) sind, die mit einer Abfasung versehen sind, die in einem zentralen Bereich (216) im wesentlichen auf demselben Pegel der inneren Oberfläche (59) beginnt.

24. Induktionsheizsystem nach Anspruch 20 und 21, dadurch gekennzeichnet, daß die Ausnehmungen im wesentlichen konische Oberflächen darstellen, auf der inneren Oberfläche (59) des Aufnehmers (12), die Spitzenwinkel (218) aufweisen, welche im wesentlichen bezüglich der Zentren der Taschen (60) ausgerichtet sind.

25. Induktionsheizsystem nach Anspruch 20 bis 24, dadurch gekennzeichnet, daß die Querecken des Aufnehmers (12) mit Abfasungen versehen sind, die außen beträchtlich größer als innen sind, um lokal die Dicke des Aufnehmers (12) aufrechtzuerhalten oder zu reduzieren, und so lokal die in den Aufnehmer eingeführte Stromdichte aufrechtzuerhalten oder zu vergrößern.

## Revendications

1. Système de chauffage par induction pour réacteur d'épitaxie, comprenant un élément sensible rotatif (12) chauffé par des courants induits par une bobine (16), logée dans un récipient en cloche (14) réalisé en un matériau isolant et optiquement transparent, tel que du quartz, entouré par un réflecteur servant à réfléchir en retour sur ledit élément sensible (12) la chaleur produite par ce dernier en fonctionnement, dans lequel ladite bobine (16) est formée par des tours (18) de conducteur creux refroidit par liquide, espacés entre eux de façon étanche pour présenter un nombre minimal d'interstices entre eux et attachés pour former un agencement mécaniquement stable, caractérisé en ce que les côtés intérieurs desdits tours (18) sont optiquement finis, c'est-à-dire qu'ils réfléchissent comme un miroir, pour servir de réflecteur et pour produire des variations de puissance locales dans l'élément sensible (12), des variations locales dans le champ magnétique produit par la bobine (16) sont produites par un moyen de réaction, par absorption ou bien par apport d'un courant relié à des tours (18) présélectionnés de la bobine (16), correspondant à des zones de l'élément sensible (12) dans lesquelles lesdites variations de puissance sont demandées et caractérisé en outre en ce que les tours (18) de la bobine (16) sont constitués de conducteurs annulaires reliés en série, situés dans des plans sensiblement perpendiculaires à l'axe de l'élément sensible (12), en vue d'induire en son sein des courants électriques présentant une direction perpendiculaire audit axe, pour éviter à des impulsions calorifiques reliées de manquer d'une certaine perpendicularité dans lesdits courants, par rapport à l'élément sensible rotatif (12), le moyen de réaction retirant du courant depuis les tours (18) présélectionnés consistant en des inducteurs (112), tandis que le moyen de réaction apportant du courant auxdits tours consiste en des condensateurs (110), ces deux types étant tous deux reliés auxdits tours (18) présélectionnés.

2. Système de chauffage par induction selon la revendication 1, caractérisé par un ventilateur (44) produisant de l'air pour refroidir ledit récipient en forme de cloche (14) à travers une buse et un générateur de tourbillons (50) et entre ledit récipient en cloche (14) et ladite bobine (16), l'air sortant ensuite de l'espace entourant ledit récipient en cloche (14) pour le passer dans un échangeur de chaleur (38), afin de revenir vers ledit ventilateur (44).

3. Système de chauffage par induction selon la revendication 2, caractérisé en ce que l'air provenant dudit ventilateur (44) entre dans une chambre pressurisée (21) et sort de cette dernière pour passer entre le récipient en cloche (14) et la bobine (16), à la fois à travers ladite buse et le générateur de tourbillons (50) et à travers des dérivations (56) supplémentaires, consistant en des interstices (56) situés entre les tours (18) de ladite bobine (16).

4. Système de chauffage par induction selon les revendications 1 à 3, caractérisé en ce que lesdits inducteurs (112) sont variables.

5. Système de chauffage par induction selon la revendication 4, caractérisé en ce que les inducteurs (112) sont rendus variables par la liaison de leurs prises à un conducteur de court-circuit (140).

6. Système de chauffage par induction selon la revendication 4, caractérisé en ce que les inducteurs (112) sont rendus variables au moyen d'un noyau ferromagnétique (114) susceptible de se déplacer en leur sein.

7. Système de chauffage par induction selon les revendications 1 à 3, caractérisé en que lesdits condensateurs (110) sont variables.

8. Système de chauffage par induction selon la revendication 7, caractérisé en ce que lesdits condensateurs (110) sont rendus variables de façon incrémentée, par une dérivation d'un nombre d'organes de condensateur pouvant être sélectionné.

9. Système de chauffage par induction selon les revendications 1 à 3, caractérisé par la combinaison d'au moins un inducteur (112) et d'un condensateur (110).

10. Système de chauffage par induction selon la revendication 9, caractérisé en ce que ladite combinaison d'au moins inducteur (112) et d'un condensateur (110) est une combinaison en parallèle de ces derniers, présentant le condensateur (110) variable de façon incrémentée et l'inducteur (112) variable au moyen d'un noyau mobile ferromagnétique (114).

11. Système de chauffage par induction selon la revendication 9, caractérisé en ce que la combinaison d'au moins un inducteur (112') et d'un condensateur (110') est une combinaison en série de ces derniers, présentant le condensateur (110') variable de façon incrémentée et l'inducteur (112') variable au moyen d'un noyau mobile ferromagnétique (114').

12. Système de chauffage par induction selon la revendication 11, caractérisé en ce que sur ledit condensateur (110') est relié un organe de limitation de tension (150) pour limiter des surtensions possibles qui peuvent être formées dans ledit condensateur (110'), dans des conditions proches de la résonance.

13. Système de chauffage par induction selon la revendication 1, caractérisé en ce que ladite bobine (16) est pourvue de blocs ferromagnétiques (160, 170, 180, 190) ayant pour fonction de guider et de limiter le champ magnétique à l'extérieur de la bobine (16).

14. Système de chauffage par induction selon la revendication 13, caractérisé en ce que lesdits blocs (160, 170, 180, 190) présentent une forme angulaire et sont respectivement prévus autour des bords supérieur et inférieur de ladite bobine.

15. Système de chauffage par induction selon la revendication 14, caractérisé en ce que lesdits blocs (160, 170, 180, 190) consistent en des empilements de lames ferromagnétiques.

16. Système de chauffage par induction selon la revendication 14, caractérisé en ce que lesdits blocs (160, 170, 180, 190) sont constitués de ferrite céramique.

17. Système de chauffage par induction selon la revendication 13, caractérisé en ce que lesdits blocs ferromagnétiques (160, 170, 180, 190) sont reliés par une enveloppe ferromagnétique extérieure, entourant et à l'extérieur de ladite bobine (16).

18. Système de chauffage par induction selon la revendication 17, caractérisé en ce que lesdits blocs (160, 170, 180, 190) et ladite enveloppe sont constitués de ferrite céramique.

19. Système de chauffage par induction selon la revendication 16, caractérisé en ce que lesdits blocs en ferrite (160, 170, 180, 190) sont reliés par des colonnes en ferrite (200), à l'extérieur de ladite bobine (16).

20. Système de chauffage par induction pour réacteur d'épitaxie selon la revendication 1, comportant un élément sensible (12) consistant en une enveloppe conductrice de l'électricité, en forme de pyramide tronquée avec une base polygonale régulière et pourvue de surfaces extérieure (58) et intérieure (59), caractérisé en ce que la surface intérieure (59) de ladite enveloppe est pourvue de creux ou de reliefs alignés et s'étendant sensiblement conjointement avec des poches ou dentures (60) réalisées sur ladite surface extérieure (58), logeant des pastilles ou des tranches (62) en matériau à traiter.

21. Système de chauffage par induction selon la revendication 20, caractérisé en ce que des variations d'épaisseur de l'élément sensible (12) compensent des variations de puissance induite, reliées à la forme pyramidale dudit élément sensible (12).

22. Système de chauffage par induction selon les revendication 20 et 21, caractérisé en ce que lesdits enfoncements alignés avec lesdites poches (60) sont des enfoncements plans présentant une forme de tranchées circulaires (210), entourant une zone centrale (212) située sensiblement au même niveau que ladite surface intérieure (59).

23. Système de chauffage par induction selon les revendications 20 et 21, caractérisé en ce que lesdits enfoncements sont des tranchées circulaires (214) pourvues d'une partie biseautée partant d'une zone centrale (216), située sensiblement au même niveau que ladite surface intérieure (59).

24. Système de chauffage par induction selon les revendication 20 et 21, caractérisé en ce que lesdits reliefs sont des surfaces globalement coniques, situées sur la surface intérieure (59) dudit élément sensible (12), présentant des sommets (248) sensiblement alignés avec les centres desdites poches (60).

25. Système de chauffage par induction selon les revendication 20 à 24, caractérisé en ce que les angles latéraux de l'élément sensible (12) sont pourvus de parties biseautées situées bien plus à l'extérieur qu'à l'intérieur, en vue de maintenir ou de réduire localement l'épaisseur de l'élément sensible (12) et ainsi de maintenir ou d'augmenter localement la densité de courant y étant présente.
